# EUROPEAN PATENT SPECIFICATION

(11) **EP 1 895 022 B1**
(45) Date of publication and mention of the grant of the patent: **14.07.2010**
(21) Application number: 07253237.7
(22) Date of filing: 16.08.2007
(51) Int. Cl.: C23C 14/22

(54) **Improved non-line of sight coating technique**
Verbessertes Nicht-Sichtverbindungs-Beschichtungsverfahren
Technique améliorée de revêtement sans visibilité

(30) Priority: 31.08.2006 US 513890
(43) Date of publication of application: 05.03.2008
(73) Proprietor: United Technologies Corporation, Hartford, CT 06101 (US)
(72) Inventor: Schlichting, Kevin W., Storrs, CT 06268 (US)
(74) Representative: Leckey, David Herbert

(56) References cited:
- EP-A- 1 384 796
- EP-A- 1 816 232
- WO-A-03/020999
- US-A- 5 720 821
- HAYASHI C: "GAS DEPOSITION" MATERIALS SCIENCE FORUM, AEDERMANNSFDORF, CH, vol. 246, 1997, pages 153-179, XP008074452 ISSN: 0255-5476

## Description

### BACKGROUND OF THE INVENTION

Due to the high temperature environment surrounding gas turbine engines, ceramic thermal barrier coatings (TBCs) are commonly applied to combustors and high turbine stationary and rotating parts to extend the life of the parts. TBCs typically consist of a metallic bond coat and a ceramic top coat applied to a nickel or cobalt based alloy. The coatings are applied at thicknesses of between approximately 125 microns and 1270 microns and can provide up to a 150 degree Celsius temperature reduction to the base metal. Thus, the coating provides the part with increased durability, allows for higher operating temperatures, and results in improved turbine efficiency.

Currently, one method of applying TBCs to a part is by an electron beam physical vapor deposition (EB-PVD) process. While effective, the EB-PVD process is a line of sight process. In a standard EB-PVD process, a vapor cloud is formed from a molten pool and drifts toward the part, where it deposits on the surface of the part. The particles in the vapor cloud have a small amount of particle-to-particle interaction, resulting in little randomization of the vapor cloud. Due to the lack of randomization, the particles are typically only deposited on the surfaces of the part that lie directly in the path emanating from the molten pool. Any region of the part that does not lie directly in the path of the vapor cloud is not coated without physically rotating the part. Thus, it would be desirable to have a system that is capable of applying a coating onto both line of sight regions as well as non-line of sight regions of a part.

EP 1816232 A1 discloses an existing PVD process which forms prior art in accordance with Article 54(3) EPC. US 5,720,821, WO 03/020999 and "Gas Deposition", Hyashi C, Materials Science Forum, Aedermannsfdorf, CH, vol. 246, 1997, pages 153-179 all disclose jet vapor deposition (JVD), which is another line of sight deposition process.

### BRIEF SUMMARY OF THE INVENTION

The present invention provides an apparatus for non-line of sight thermal barrier coating of a part, as set forth in claim 1.

The present invention also provides a method of coating non-line of sight regions of a part with a thermal barrier coating, as set forth in claim 6.

Preferred embodiments of the invention are disclosed in dependent claims 2 to 5 and 7 to 9.

### BRIEF DESCRIPTION OF THE DRAWINGS

FIG. 1 is a side view of a non-line of sight coating system.
FIG. 2 is a block diagram of a method of coating non-line of sight regions of a part.

### DETAILED DESCRIPTION

The non-line of sight coating system provides improved resistance to oxidation and thermal mechanical fatigue by comprehensively applying a thermal barrier coating to a part. The part is positioned within a housing that is maintained at a low pressure by a vacuum pumping system. A shaft positions the part between a vapor source and an inert gas source. The vapor source introduces a vapor cloud into the housing toward the line of sight regions of the part. The inert gas is introduced into the housing toward the non-line of sight regions of the part by a plurality of nozzles attached to a shield. As the vapor cloud and the inert gas interact, particle-to-particle collisions cause randomization of the vapor cloud and push the vapor cloud back toward the non-line of sight regions of the part. Thus, the coating system coats the non-line of sight regions of the part, accelerates coating of the line of sight regions of the part, and improves the microstructure of the areas of the part that are not in direct alignment with the vapor source.

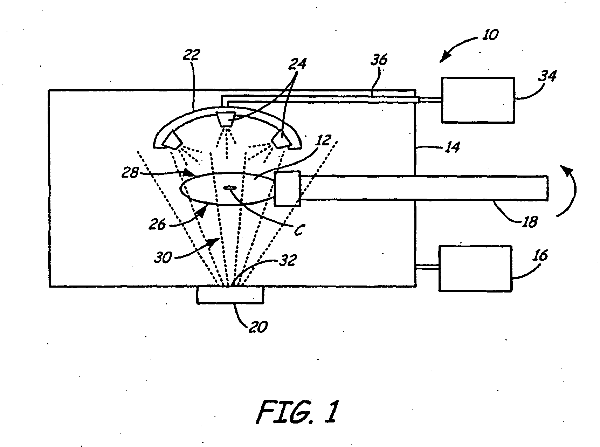

FIG. 1 shows a side view of non-line of sight coating system 10 for coating a part 12. Coating system 10 generally includes housing 14, vacuum pumping system 16, shaft 18, vapor source 20, shield 22, and nozzles 24. Coating system 10 may be retrofitted into current vapor coating processes to apply a thermal barrier coating (TBC) to line of sight regions 26 and non-line of sight regions 28 of part 12. In addition, coating system 10 also accelerates line of sight coating of part 12. Coating part 12 with TBC increases the life of part 12 by preventing failure due to oxidation and thermal mechanical fatigue.

The TBC is applied to part 12 within housing 14, which provides a low pressure environment. Vacuum pumping system 16 is connected to housing 14 and maintains the pressure within housing 14 by continuously pumping air out of housing 14. The pressure within housing 14 is maintained below atmospheric pressure. In an exemplary embodiment, the pressure within housing 14 is maintained at between approximately 6 X 10⁻⁵ millibar and approximately 2 X 10⁻³ millibar.

As can be seen in FIG. 1, part 12 is positioned in housing 14 by shaft 18. Shaft 18 positions part 12 in housing 14 substantially halfway between vapor source 20 and shield 22. When part 12 is stationary within housing 14, line of sight regions 26 are in direct alignment with vapor source 20 and non-line of sight regions 28 are in direct alignment with shield 22 and nozzles 24. In an exemplary embodiment, shaft 18 is a rotatable shaft that is capable of exposing all sides of part 12 to vapor source 20. In this case, shaft 18 allows part 12 to pivot radially about a center point C of part 12. This allows line of sight regions 26 to be in direct alignment with shield 22 and nozzles 24, and non-line of sight regions 28 to be in direct alignment with vapor source 20.

Vapor source 20 is positioned immediately adjacent to housing 14 and introduces vapor cloud 30 into housing 14 at aperture 32 of housing 14. Vapor cloud 30 includes the TBC to be coated onto part 12. As vapor cloud 30 reaches part 12, the TBC condenses on part 12 and is applied onto line of sight regions 26 of part 12.

Shield 22 is semi-hemispherical in shape and is positioned within housing 14 opposite vapor source 20 to position nozzles 24 relative to part 12. In an exemplary embodiment, shield 22 surrounds part 12 up to about 180 degrees. Shield 22 and nozzles 24 are connected to an inert gas source 34 through piping 36. Nozzles 24 receive inert gas from inert gas source 34 and provide a gas flow into housing 14. Because vacuum pumping system 16 maintains housing 14 at a low pressure, nozzles 24 need to provide the inert gas at a relatively low pressure. In an exemplary embodiment, nozzles 24 introduce inert gas into housing 14 at a rate of between approximately 0.1 liters per minute (L/min) and approximately 10 L/min. The flow of inert gas from nozzles 24 may be adjusted to maintain particle flow from vapor source 20. Although FIG. 1 depicts coating system 10 as including three nozzles 24, coating system 10 may optionally include any number of nozzles, including only one nozzle, depending on the geometry of part 12 and coating requirements. Although inert gas source 34 is discussed as providing inert gas, inert gas source 34 may also provide other gases that may react chemically with the particles of vapor cloud 30, such as oxygen.

The inert gas from nozzles 24 function to push vapor cloud 30 back toward part 12. As the inert gas from nozzles 24 meets vapor cloud 30, the inert gas causes particle-to-particle interactions and increases randomization within vapor cloud 30. The random collisions allow the particles to have different trajectories toward part 12 and specifically, to non-line of sight regions 28. By creating a randomized vapor cloud, coating system 10 coats non-line of sight regions 28 of part 12, accelerates coating line of sight regions 26 of part 12, and improves the microstructure in regions of part 12 that are slightly off angle to vapor source 20. In an exemplary embodiment, part 12 is completely coated after being positioned in housing 14 for between approximately 20 minutes and approximately 120 minutes.

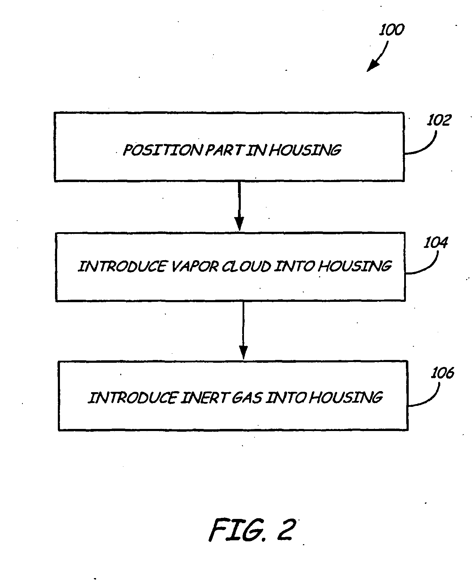

FIG. 2 shows a block diagram of an exemplary, non-limiting method 100 of coating non-line of sight regions 28 of part 12. Conventional coating techniques typically only coat line of sight regions 26 of part 12. Method 100 allows coating non-line of sight regions 28 as well as line of sight regions 26 of part 12. As shown in Box 102, part 12 is first positioned in housing 14 between vapor source 20 and shield 22 with nozzles 24. Vapor cloud 30 is introduced into housing 14 by vapor source 20, coating line of sight regions 26 of part 12, as shown in Box 104. As vapor cloud 30 is being introduced into housing 14, nozzles 24 provide a gas flow of inert gas from inert gas source 34 to interact with vapor cloud 30, Box 106. As the inert gas interacts with vapor cloud 30, the particle-to-particle interactions create a randomized cloud. The randomized cloud pushes back toward part 12 and coats non-line of sight regions 28. During this process, the coating of line of sight regions 26 is also accelerated, and the microstructure in areas of part 12 that were slightly off angle to vapor source 20 are also improved.

Although the present invention has been described with reference to preferred embodiments, workers skilled in the art will recognize that changes may be made in form and detail without departing from the scope of the invention.

## Claims

1. An apparatus (10) for non-line of sight thermal barrier coating of a part (12), the apparatus comprising:
a housing (14);
a vapor source (20) for producing a vapor cloud (30) of a thermal barrier coating material into the housing (14) toward the part (12);
a shield (22) positioned within the housing (14) opposite the vapor source (20);
at least one nozzle (24) attached to the shield (22) and positioned for providing a gas flow to interact with the vapor cloud (30) and push the vapor cloud (30) back toward non-line of sight regions of the part (12); and
a vacuum pumping system (16) for maintaining a pressure within the housing (14) below atmospheric pressure.

2. The apparatus of claim 1, and further comprising a shaft (18) for positioning the part (12) within the housing (14) between the vapor source (20) and the nozzle (24).

3. The apparatus of claim 2, wherein the shaft (18) is a rotatable shaft.

4. The apparatus of any preceding claim, wherein the shield (22) is semi-hemispherical.

5. The apparatus of any preceding claim, and further comprising a plurality of nozzles (24).

6. A method of coating non-line of sight regions of a part (12) with a thermal barrier coating, the method comprising:
positioning the part (12) within an enclosed housing (14);
producing a vapor cloud (30) using a vapor source (20) of a thermal barrier coating material into the housing (14) toward the part (12);
providing a shield (22) within the housing (14) opposite the vapor source (20);
providing a gas flow into the housing (14) toward the non-line of sight regions (28) of the part (12) using at least one nozzle (24) attached to the shield (22), wherein the gas flow interacts with the vapor cloud (30) and pushes the vapor cloud (30) back toward the non-line of sight regions (28) of the part (12); and
maintaining the enclosed housing (14) within a predetermined pressure range below atmospheric pressure.

7. The method of claim 6, wherein positioning the part (12) within an enclosed housing (14) comprising using a shaft (18).

8. The method of claim 6 or 7, wherein the gas flow interacts with the vapor cloud (30) to create a randomized cloud.

9. The method of claim 6, 7 or 8, wherein gas flow from the nozzle (24) is selected from the group consisting of: an inert gas and oxygen.

## Patentansprüche

1. Vorrichtung (10) für eine nicht in der Sichtlinie erfolgende Wärmebarrierenbeschichtung eines Teil (12), wobei die Vorrichtung Folgendes aufweist:
ein Gehäuse (14);
eine Dampfquelle (20) zum Erzeugen einer Dampfwolke (30) eines Wärmebarrieren-Beschichtungsmaterials in dem Gehäuse (14) zu dem Teil (12) hin;
eine Abschirmung (22), die in dem Gehäuse (14) gegenüber der Dampfquelle (20) angeordnet ist;
mindestens eine Düse (24), die an der Abschirmung (22) angebracht ist und
zum Schaffen einer Gasströmung für die Wechselwirkung mit der Dampfwolke (30) und zum Drücken der Dampfwolke (30) zurück in Richtung auf nicht in der Sichtlinie liegende Bereiche des Teils (12) positioniert ist; und
ein Vakuumpumpsystem (16) zum Halten eines Drucks innerhalb des Gehäuses (14) unter dem Atmosphärendruck.

2. Vorrichtung nach Anspruch 1,
weiterhin aufweisend einen Schaft (18) zum Positionieren des Teils (12) innerhalb des Gehäuses (14) zwischen der Dampfquelle (20) und der Düse (24).

3. Vorrichtung nach Anspruch 2,
wobei es sich bei dem Schaft (18) um einen drehbaren Schaft handelt.

4. Vorrichtung nach einem der vorausgehenden Ansprüche,
wobei die Abschirmung (22) halbkugelförmig ausgebildet ist.

5. Vorrichtung nach einem der vorausgehenden Ansprüche,
die weiterhin eine Mehrzahl von Düsen (24) aufweist.

6. Verfahren zum Beschichten von nicht in der Sichtlinie liegenden Bereichen eines Teils (12) mit einer Wärmebarrierenbeschichtung, wobei das Verfahren folgende Schritte aufweist:
Positionieren des Teils (12) im Inneren eines umschlossenen Gehäuses (14);
Erzeugen einer Dampfwolke (30) unter Verwendung einer Dampfquelle (20) aus einem Wärmebarrieren-Beschichtungsmaterial in dem Gehäuse (14) zu dem Teil (12) hin;
Bereitstellen einer Abschirmung (22) in dem Gehäuse (14) gegenüber der Dampfquelle (20);
Bereitstellen einer Gasströmung in das Gehäuse (14) in Richtung auf nicht in der Sichtlinie liegende Bereiche (28) des Teils (12) unter Verwendung von mindestens einer an der Abschirmung (22) angebrachten Düse (24), wobei die Gasströmung mit der Dampfwolke (30) in Wechselwirkung tritt und die Dampfwolke (30) zurück in Richtung auf die nicht in der Sichtlinie liegenden Bereiche (28) des Teils (12) drückt; und
Halten des umschlossenen Gehäuses (14) innerhalb eines vorbestimmten Druckbereichs unter dem Atmosphärendruck.

7. Verfahren nach Anspruch 6,
wobei das Positionieren des Teils (12) innerhalb eines umschlossenen Gehäuses (14) die Verwendung eines Schafts (18) beinhaltet.

8. Verfahren nach Anspruch 6 oder 7,
wobei die Gasströmung mit der Dampfwolke (30) in Wechselwirkung tritt, um eine zufallsmäßige Wolke zu erzeugen.

9. Verfahren nach Anspruch 6, 7 oder 8,
wobei die Gasströmung von der Düse (24) aus der Gruppe ausgewählt wird, die aus Inertgas und Sauerstoff besteht.

## Revendications

1. Appareil (10) pour revêtement de barrière thermique sans visibilité d'une pièce (12), l'appareil comprenant :
un logement (14) ;
une source de vapeur (20) pour produire un nuage de vapeur (30) d'un matériau de revêtement de barrière thermique dans le logement (14) vers la pièce (12) ;
un écran de protection (22) positionné dans le logement (14) à l'opposé de la source de vapeur (20) ;
au moins une buse (24) attachée à l'écran de protection (22) et positionnée pour fournir un écoulement de gaz pour interagir avec le nuage de vapeur (30) et repousser le nuage de vapeur (30) vers des régions sans visibilité de la pièce (12); et
un système de pompage à vide (16) pour maintenir une pression dans le logement (14) en dessous de la pression atmosphérique.

2. Appareil selon la revendication 1, comprenant en outre un arbre (18) pour positionner la pièce (12) dans le logement (14) entre la source de vapeur (20) et la buse (24).

3. Appareil selon la revendication 2, dans lequel l'arbre (18) est un arbre rotatif.

4. Appareil selon l'une quelconque des revendications précédentes, dans lequel l'écran de protection (22) est semi-hémisphérique.

5. Appareil selon l'une quelconque des revendications précédentes, comprenant en outre une pluralité de buses (24).

6. Procédé de revêtement de régions sans visibilité d'une pièce (12) avec un revêtement de barrière thermique, le procédé comprenant :
le positionnement de la pièce (12) dans un logement enfermé (14) ;
la production d'un nuage de vapeur (30) à l'aide d'une source de vapeur (20) d'un matériau de revêtement de barrière thermique dans le logement (14) vers la pièce (12) ;
la fourniture d'un écran de protection (22) dans le logement (14) à l'opposé de la source de vapeur (20) ;
la fourniture d'un écoulement de gaz dans le logement (14) vers les régions sans visibilité (28) de la pièce (12) à l'aide d'au moins une buse (24) attachée à l'écran de protection (22), où l'écoulement de gaz interagit avec le nuage de vapeur (30) et repousse le nuage de vapeur (30) vers les régions sans visibilité (28) de la pièce (12) ; et
le maintien du logement enfermé (14) dans une plage de pression prédéterminée en dessous de la pression atmosphérique.

7. Procédé selon la revendication 6, dans lequel le positionnement de la pièce (12) dans un logement enfermé (14) comprend l'utilisation d'un arbre (18).

8. Procédé selon la revendication 6 ou 7, dans lequel l'écoulement de gaz interagit avec le nuage de vapeur (30) pour créer un nuage aléatoire.

9. Procédé selon la revendication 6, 7 ou 8, dans lequel l'écoulement de gaz provenant de la buse (24) est choisi dans le groupe consistant en : un gaz inerte et l'oxygène.
